# EUROPEAN PATENT APPLICATION

(11) **EP 4 790 895 A1**
(43) Date of publication of application: **12.08.2026**
(21) Application number: 26150970.7
(22) Date of filing: 09.01.2026
(51) Int. Cl.: H03K 3/0231

(54) **FREQUENCY TRIMMABLE CLOCK SIGNAL GENERATOR AND METHOD THEREOF**

(30) Priority: 10.01.2025 US 202563743652 P; 08.01.2026 US 202619443046
(71) Applicant: xMEMS Labs, Inc., Santa Clara, CA 95051 (US)
(72) Inventor: Lin, Yu-Chun, 710 Tainan City (TW)
(74) Representative: Straus, Alexander

(57) **Abstract**

A clock signal generator includes an oscillation circuit and a charge moving capacitor. The oscillation circuit is configured to generate a clock signal and comprises a comparator and a resistor-capacitor (RC) circuit, wherein the RC circuit comprises a capacitor. The charge moving capacitor is connected to the RC circuit. A frequency of the clock signal is trimmed by injecting or extracting electric charges associated with the RC circuit via the charge moving capacitor.

## Description

### Field of the Invention

The present application relates to a clock signal generator and a frequency trimming method, and more particularly, to a clock signal generator and a frequency trimming method capable of trimming clock frequency with high resolution.

### Background of the Invention

Unless otherwise indicated herein, the approaches described in this section are not prior art to the claims in this application and are not admitted as prior art by inclusion in this section.

US Patent No. 11,943,585 or Application No. 19/035,763 discloses an air pulse generating (APG) device, which can be used as a sound producing device. As mentioned in No. 11,943,585 or No. 19/035,763, the operating frequency of the APG device would affect the sound pressure level (SPL). Specifically, the SPL is determined by how closely the operating frequency approaches the resonant frequency.

However, the resonant frequency of APG devices varies due to fabrication variations. Consequently, the operating frequency must be precisely calibrated to match the specific resonant frequency of each individual APG device.

Therefore, a frequency-trimmable clock signal generator is desirable to compensate for these variations and ensure optimal performance.

### Summary of the Invention

The present invention therefore provides a clock signal generator and a frequency trimming method, in order to improve over disadvantages of the prior art.

This is achieved by a clock signal generator according to independent claim 1 and a frequency trimming method according to claim 14. The dependent claims pertain to corresponding further developments and improvements.

As will be seen more clearly from the detailed description following below, the claimed clock signal generator comprises an oscillation circuit, configured to generate a clock signal, comprising a comparator and a resistor-capacitor (RC) circuit, wherein the RC circuit comprising a capacitor; and a charge moving capacitor, connected to the RC circuit; wherein a frequency of the clock signal is trimmed by injecting or extracting electric charges associated with the RC circuit via the charge moving capacitor.

### Brief Description of the Drawings

FIG. 1 is a schematic diagram of a frequency-trimmable clock signal generator according to an embodiment of the present invention.
FIG. 2 illustrates a schematic diagram of an oscillation circuit and related waveforms.
FIG. 3 illustrates a schematic diagram of a frequency-trimmable clock signal generator and related waveforms.
FIG. 4 illustrates another (relaxation) oscillator or an oscillation circuit and its corresponding waveforms.
FIG. 5 illustrates a schematic diagram of a frequency-trimmable clock signal generator.
FIG. 6 illustrates a schematic diagram of a frequency-trimmable clock signal generator.
FIG. 7 is a schematic diagram of an oscillation circuit with its operations.
FIG. 8 is a schematic diagram of a frequency-trimmable clock signal generator according to an embodiment of the present invention.
FIG. 9 illustrates waveforms of clock signals and capacitor voltages.
FIG. 10 illustrates the charge moving capacitor in FIG. 8 realized by an equivalent charge moving capacitor.
FIG. 11 is a schematic diagram of a frequency-trimmable clock signal generator according to an embodiment of the present invention.

### Detailed Description

In the present invention, a frequency-trimmable clock signal generator is proposed. Moreover, the frequency trimming is achieved via a charge injection/extraction mechanism, where the quantity of injected/extracted charge and/or the delay time are utilized as control parameters. The clock frequency can be adjusted monotonically, providing high-resolution compensation for the aforementioned fabrication variations.

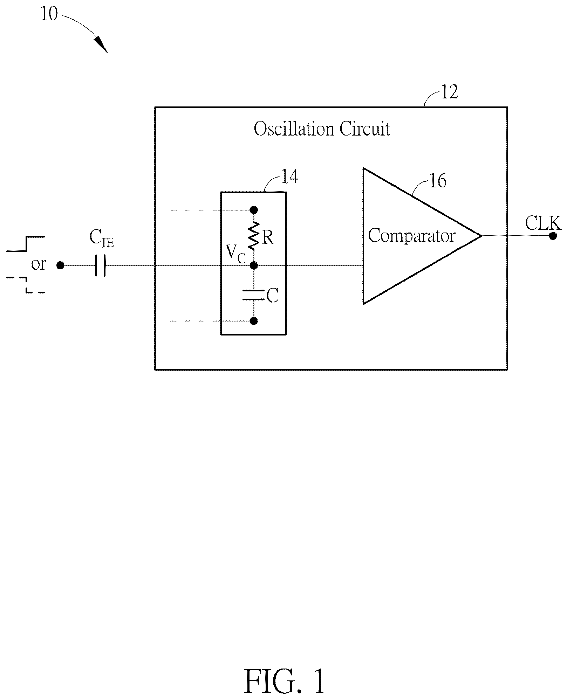

FIG. 1 is a schematic diagram of a frequency-trimmable clock signal generator 10 according to an embodiment of the present invention. The frequency-trimmable clock signal generator 10 comprises an oscillation circuit 12 and a charge moving capacitor C_{IE}. The oscillation circuit 12, which may be a relaxation oscillator, comprises a resistor-capacitor (RC) circuit 14 and a comparator 16. The output of the comparator 16 usually would be feedback to the oscillation circuit 12, to switch between a charging state/phase and a discharging state/phase. The RC circuit 14 performs charging operation or discharging operation, so that a capacitor voltage V_{C} would either increase (when charging) or decrease (when discharging). When the capacitor voltage V_{C} increases or decreases to across a threshold value, the comparator 16 would change state and produce a clock signal CLK.

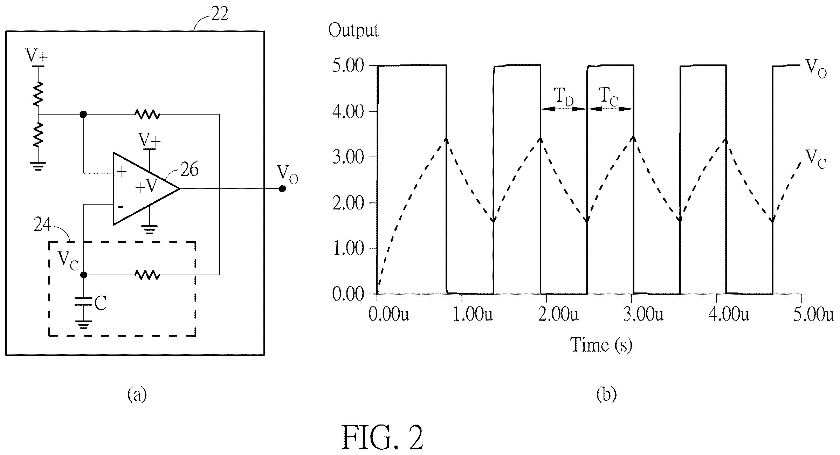

For example, FIG. 2(a) illustrates a schematic diagram of an oscillation circuit 22 and FIG. 2(b) illustrates waveforms of an output voltage Vo and a capacitor voltage V_{C}. FIG. 2 is excerpted from https://www.ti.com/lit/pdf/snoa998. The oscillation circuit 22 comprises an RC circuit 24 and a comparator 26. The oscillation circuit 22 comprises a capacitor C. During a discharging period T_{D}, the output voltage Vo is low, and the capacitor C discharges, causing the capacitor voltage V_{C} to decrease. Once the capacitor voltage V_{C} decreases to a first level, the comparator 26 is triggered to change state, causing the output voltage Vo to transit to a high state, and a charging period T_{C} begins. During the charging period T_{C}, the capacitor C charges and the capacitor voltage V_{C} increases. Once the capacitor voltage V_{C} reaches a second level, the comparator 26 is triggered to change state again (to a low state), and another discharging period T_{D} begins.

As can be seen from FIG. 2, through capacitor charging and discharging, the oscillation circuit 22 is able to output Vo as a square wave (which can be used as a clock signal). The frequency of the clock (or clock frequency) is strictly determined by an RC time constant of the RC circuit, which is not trimmable.

In order to be frequency-trimmable, a charge moving capacitor can be included.

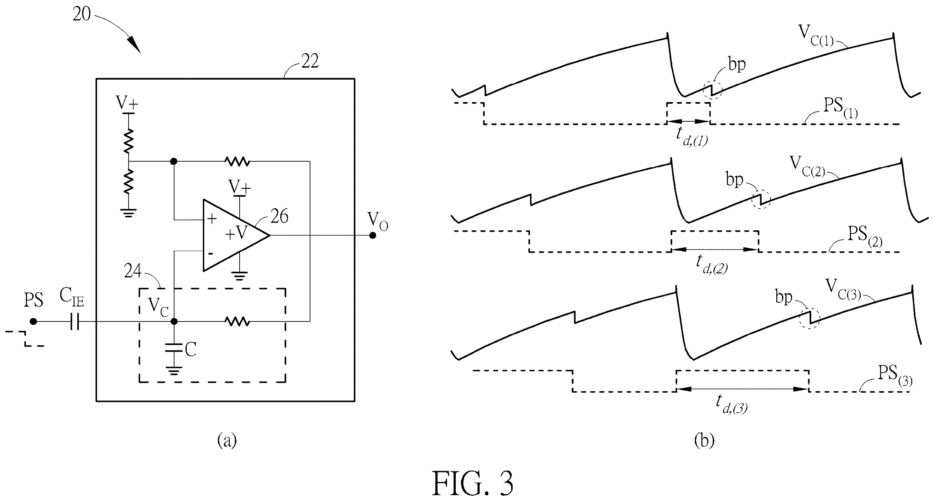

FIG. 3(a) illustrates a schematic diagram of a frequency-trimmable clock signal generator 20. In addition to the oscillation circuit 22, charge moving capacitor C_{IE} is included. A first end of the charge moving capacitor C_{IE} is coupled to the RC circuit 24 or the capacitor C therein. A second end of the charge moving capacitor C_{IE} receives a signal PS. In general, the signal PS may comprise a rising edge or a falling edge, where the rising edge may lie in the discharging period or the falling edge may lie in the charging period. In the embodiment shown in FIG. 3, the falling edge lies in the charging period.

For example, FIG. 3(b) illustrates waveforms of pulse signals PS₍₁₎, PS₍₂₎, PS₍₃₎, corresponding to various duty/delay times *t*_{*d*,(1)}, *t*_{*d,*(2)}*, t*_{*d,*(3)}, and capacitor voltages V_{C(1)}, V_{C(2)}, V_{C(3)}, corresponding to the pulse signals PS₍₁₎, PS₍₂₎, PS₍₃₎. The pulse signals PS₍₁₎, PS₍₂₎, PS₍₃₎ comprises a falling edge within the charging period of the capacitor C. Given the charge moving capacitor C_{IE} receives the pulse signal PS₍₁₎/PS₍₂₎/PS₍₃₎ at the second end thereof, at the time (instant) corresponding to the falling edge, electric charges are extracted from the capacitor C via the charge moving capacitor C_{IE}, the capacitor voltage V_{C(1)}/V_{C(2)}/V_{C(3)} slightly drops during the charging period. Thereby, the waveform of the capacitor voltage V_{C(1)}/V_{C(2)}/V_{C(3)} would comprise a bump bp toward negative or with negative polarity. Hence, due to the charge extraction, the charging period is lengthened, and the clock frequency is trimmed lower.

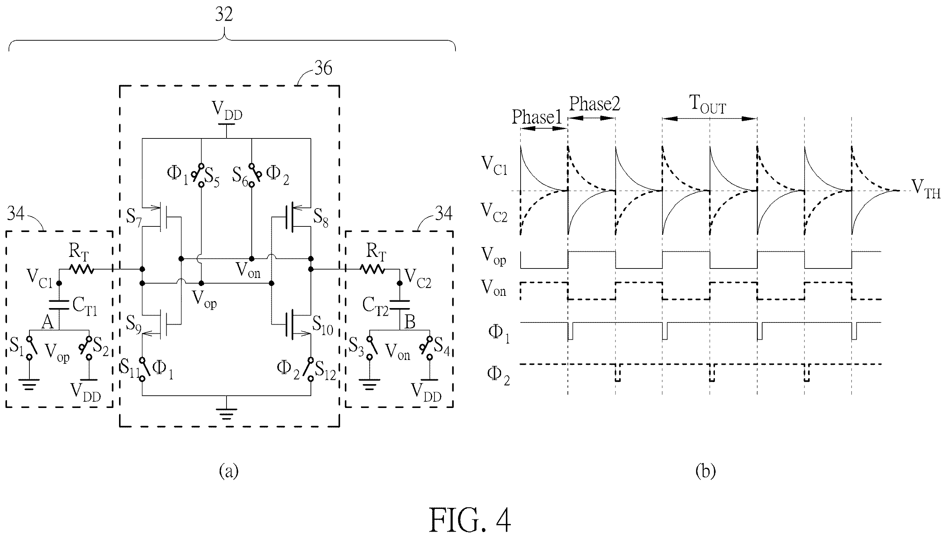

FIG. 4 illustrates another (relaxation) oscillator or an oscillation circuit 32 and its corresponding waveforms, excerpted from S. -Y. Lu and Y. -T. Liao, "A Low-Power, Differential Relaxation Oscillator With the Self-Threshold-Tracking and Swing-Boosting Techniques in 0.18-µm CMOS," in IEEE Journal of Solid-State Circuits, vol. 54, no. 2, pp. 392-402, Feb. 2019. The oscillation circuit 32 comprises RC circuit 34 and (inverter-based) comparator 36. The RC circuit 34 comprises capacitors C_{T1}, C_{T2}. Similar to the oscillation circuit 22, during the high/low state of the (output) voltage Vₒₚ/Vₒₙ, the capacitor C_{T1}/C_{T2} performs charging and discharging alternatively. The clock frequency of the oscillation circuit 32 is determined by the RC time constant, which is not frequency-trimmable.

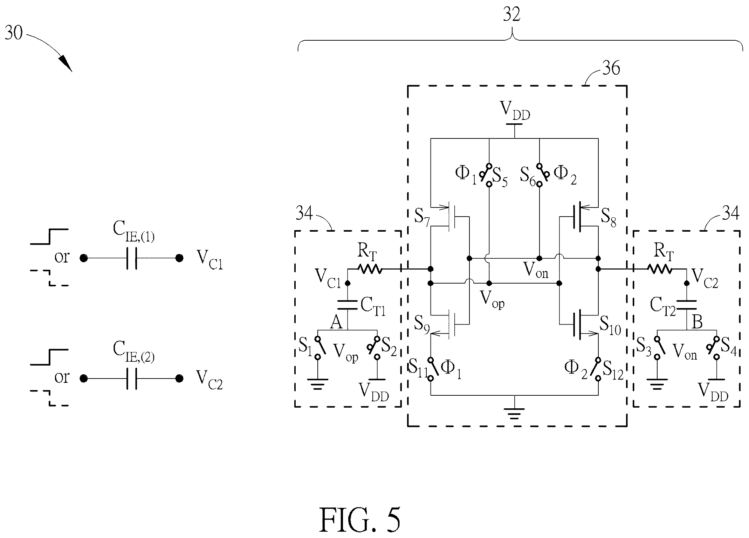

FIG. 5 illustrates a schematic diagram of a frequency-trimmable clock signal generator 30. In addition to the oscillation circuit 32, charge moving capacitors C_{IE,(1)}, C_{IE,(2)} are included. A first end of the charge moving capacitors C_{IE,(1)}, C_{IE,(2)} may be coupled to the capacitors C_{T1}, C_{T2}. A second end of the charge moving capacitors C_{IE,(1)}, C_{IE,(2)} may receive signal(s) comprising rising/falling edge, so as to inject electric charge into or extract electric charge from the capacitor C_{T1}/C_{T2} in the RC circuit 34.

In the present invention, "signal comprising rising/falling edge" generally represents that the signal comprises a (sudden) voltage change from a first voltage to a second voltage.

In an embodiment, the second end of the charge moving capacitor may receive another clock signal. In an embodiment, the another clock signal may be a delayed version of the clock signal outputted by the oscillation circuit of the frequency-trimmable clock signal generator.

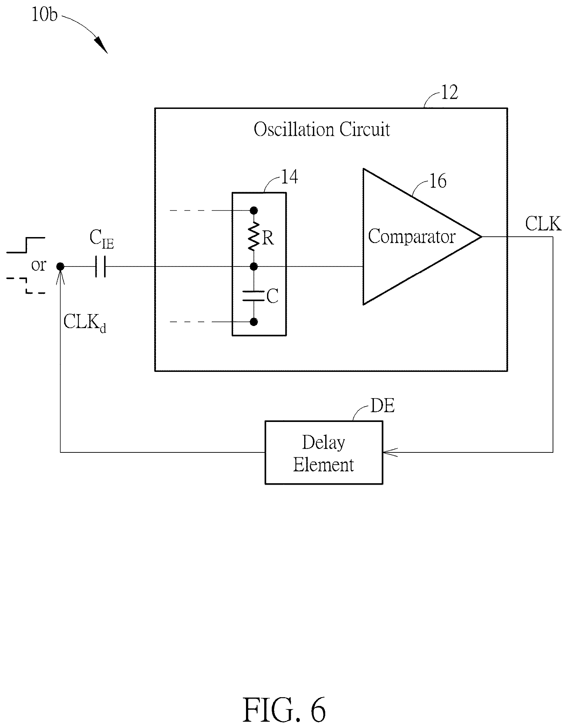

FIG. 6 illustrates a schematic diagram of a frequency-trimmable clock signal generator 10b. The clock signal generator 10b is similar to the clock signal generator 10. In addition to the clock signal generator 10, the clock signal generator 10b further comprises a delay element DE, coupled between the oscillation circuit 12 (actually the output terminal of the comparator 16) and the second end of the charge moving capacitor C_{IE}. The delay element DE is configured to produce a delayed clock signal CLK_{d}, generated according to the clock signal CLK, to the second end of the charge moving capacitor C_{IE}. Details of the operations regarding the delayed clock signal CLK_{D} will be discussed later.

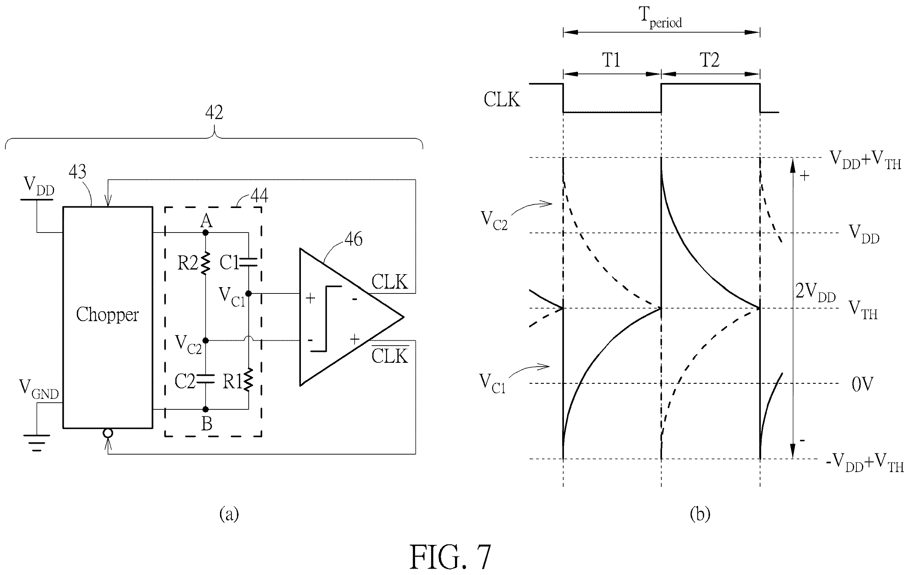

FIG. 7(a) is a schematic diagram of an oscillation circuit 42. The oscillation circuit 42 is configured to generate a clock signal CLK. The oscillation circuit 42 comprises a chopping circuit 43, a RC circuit 44 and a comparator 46. FIG.7 is excerpted from J. Lee, A. K. George and M. Je, "An Ultra-Low-Noise Swing-Boosted Differential Relaxation Oscillator in 0.18-µm CMOS," in IEEE Journal of Solid-State Circuits, vol. 55, no. 9, pp. 2489-2497, Sept. 2020.

The chopping circuit 43 connects nodes A and B. In the embodiment shown in FIG. 7(a), the chopping circuit 43 also connects to a power supply (to receive a first voltage, e.g., V_{DD}) and a ground (to receive a second/ground voltage, e.g., V_{GND}), but not limited thereto. During a first time (e.g., corresponding to a first state (e.g., high state) of the clock signal CLK), the chopping circuit provides the first voltage (e.g., V_{DD} from the power supply) to the node A and provides the second voltage (e.g., V_{GND} from the ground) to the node B. During a second time (e.g., corresponding to a second state (e.g., low state) of the clock signal CLK), the chopping circuit provides the second voltage (e.g., V_{GND} from the ground) to the node A and provides the first voltage (e.g., V_{DD} from the power supply) to the node B.

The RC circuit 44 comprises capacitors C1, C2 and resistors R1, R2. The capacitor C1 and the resistor R1 are connected as a first series connection. The capacitor C2 and the resistor R2 are connected as a second series connection. The first series connection and the second series connection are connected in parallel between node A and node B.

Note that, the resistors R1, R2 and the capacitors C1, C2 within the RC circuit 44 of the present invention are for illustrative purposes. Components with electric resistance and electric capacitance can replace R1, R2, C1, C2 within the RC circuit 44 of the present invention. That is, the resistors and capacitors of the present invention are symbolic representations of components with resistance and capacitance. They refer not only to physical discrete resistors and capacitors but also to any components that exhibit equivalent resistance or capacitance.

The comparator 46 comprises a first input terminal (denoted as "+") and a second input terminal (denoted as "-"). The first input terminal is coupled between the capacitor C1 and the resistor R1. The second input terminal is coupled between the capacitor C2 and the resistor R2.

Operations of the oscillation circuit 42 may be illustrated in FIG. 7(b). During a time T1, the clock signal CLK is in low state (or the comparator 46 outputs low state), node B receives the voltage V_{DD} and node A receives the voltage V_{GND}. Suppose V_{DD} > V_{GND}, electric current flows from node B to node A, the capacitor C2 is discharging and the capacitor C1 is charging, voltage V_{C2} decreases and voltage V_{C1} increases. The time T1 can be viewed as a charging period of the capacitor C1 or a discharging period of the capacitor C2.

Once threshold condition is achieved (e.g., V_{C1} = V_{C2}), the comparator 46 transits/changes its to high state (or the clock signal CLK transits to high state), node A switches to the voltage V_{DD} and node B switches to the voltage V_{GND}. During a time T2, given V_{DD} > V_{GND}, electric current flows from node A to node B, the capacitor C1 is discharging and the capacitor C2 is charging, the voltage V_{C1} decreases and voltage V_{C2} increases, until threshold condition (e.g., V_{C1} = V_{C2}) is met again. The time T2 can be viewed as a discharging period of the capacitor C1 or a charging period of the capacitor C2.

The frequency of the clock signal CLK generated by the oscillation circuit 42 shown in FIG. 7 is purely determined by the resistance and the capacitance of the RC circuit. Once the resistance or the capacitance of the RC circuit is selected, the frequency of the clock signal CLK is fixed/constant.

However, frequency-trimmable clock signal generator is desirable for some applications. For example, the frequency trimmable clock generator may be used to generate system clock signal for driving circuit which is to driving an air pulse generating (APG) device disclosed in US Patent No. 11,943,585 or Application No. 19/035,763 as a sound producing device, where a sound pressure level (SPL) would be affected by operating frequency thereof, as mentioned in US Application No. 19/289,091 and/or No. 19/287,761. Specifically, the SPL is determined by how closely the operating frequency approaches the resonant frequency. Since the resonant frequency of APG devices varies due to fabrication variations, it is desirable to design a frequency-trimmable clock signal generator to compensate for these variations and ensure optimal performance.

The purpose of the present invention is to propose a frequency-trimmable clock signal generator.

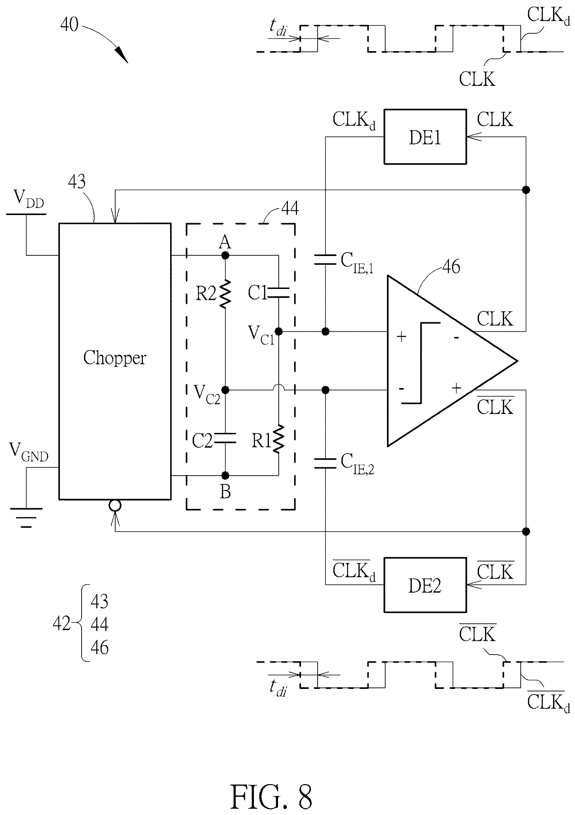

FIG. 8 is a schematic diagram of a frequency-trimmable clock signal generator 40 according to an embodiment of the present invention. In addition to the oscillation circuit 42, the clock signal generator 40 further comprises charge moving capacitors C_{IE,1} and C_{IE,2}, coupled to the first and second input terminals of the comparator 46 or coupled to the capacitors C1 and C2. The charge moving capacitor C_{IE,1/2} is configured to inject/extract electric charges to/from the capacitance associated with the RC circuit 44, so that the (dis)charging period can be prolonged and thus frequency of the clock signal can be trimmed.

In other words, a first end of the charge moving capacitor C_{IE,1}/ C_{IE,2} is coupled to the RC circuit 44 and/or the comparator 46. A second end of charge moving capacitor C_{IE,1}/ C_{IE,2} may receive/experience a sudden (or short term) voltage rising-up to inject electric charges to the RC circuit 44, or may receive/experience a sudden (or short term) voltage falling-down to extract electric charges from the RC circuit 44.

In an embodiment, the second end of charge moving capacitor C_{IE,1}/ C_{IE,2} may receive a signal comprising a rising edge at a time instant within a discharging period, to inject electric charges to the RC circuit 44. In an embodiment, the second end of charge moving capacitor C_{IE,1}/ C_{IE,2} may receive a signal comprising a falling edge at a time instant within a charging period to extract electric charges from the RC circuit 44.

In an embodiment, the second end of charge moving capacitor C_{IE,1} may receive a delayed version of the clock signal (or delayed clock signal) CLK_{d}; while the second end of charge moving capacitor C_{IE,2} may receive a delayed version of a complementary clock signal (or delayed-and-complementary clock signal) C̅L̅K̅_{d}, where the complementary clock signal CLK is a complement of the clock signal CLK, the clock signal CLK is outputted from a first output terminal of the comparator 46, and the complementary clock signal CLK is outputted from a second output terminal of the comparator 46, as shown in FIG. 7 and FIG. 8.

In the embodiment shown in FIG. 8, the (frequency-trimmable) clock signal generator 40 comprises delay elements DE1 and DE2. The delay element DE1 is coupled between the charge moving capacitor C_{IE,1} and the first output terminal of the comparator 46 (denoted as "-"). The delay element DE2 is coupled between the charge moving capacitor C_{IE,2} and the second output terminal of the comparator 46 (denoted as "+"). The delay element DE1 produces the delayed clock signal CLK_{d} to the charge moving capacitor C_{IE,1}. The delay element DE2 produces the delayed-and-complementary clock signal C̅L̅K̅_{d} to the charge moving capacitor C_{IE,2}.

In an embodiment, the delay element DE1 produces the delayed clock signal CLK_{d} having a delay time (e.g., *t_{di}*) with respect to the clock signal CLK to the charge moving capacitor C_{IE,1}, and the delay element DE2 produces the delayed-and-complementary clock signal C̅L̅K̅_{d} having a delay time (e.g., *t_{di}*) with respect to the complementary clock signal CLK to the charge moving capacitor C_{IE,2}. Note that, the delay time *t_{di}* applied for the delay element DE1 and the delay time *t_{dj}* applied for the delay element DE2 may or may not be different, both cases are within the scope of the present invention.

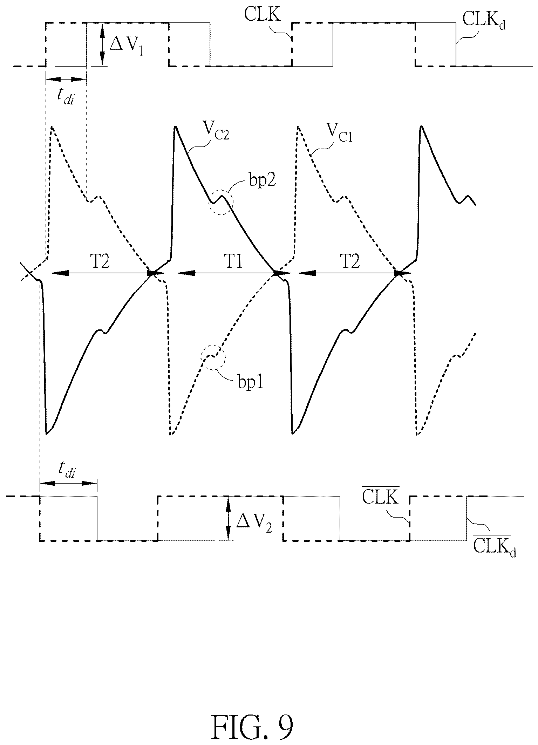

Waveforms of clock signals CLK, CLK_{d}, C̅L̅K̅, C̅L̅K̅_{d} and capacitor voltages V_{C1}, V_{C2} are illustrated in FIG. 9. Note that, the frequency-trimmable clock signal generators 30 and 40 may both be able to generate the waveforms of the capacitor voltages V_{C1}, V_{C2}.

During time period T1, the clock signal CLK is low and the complementary clock signal C̅L̅K̅ is high. The capacitor C1 is charging and the capacitor C2 is discharging. T1 can be regarded as a charging period of the capacitor C1 and/or a discharging period of the capacitor C2.

As the delayed-and-complementary clock signal C̅L̅K̅_{d} has a rising edge within the discharging period of the capacitor C2, electric charges with a quantity of ΔV₂· C_{IE,2} are injected into the capacitor C2 via the charge moving capacitor C_{IE,2}, which causes a bump bp2 (with positive polarity) on a waveform of the voltage V_{C2}. On the other hand, as the delayed clock signal CLK_{d} has a falling edge within the charging period of the capacitor C1, electric charges with a quantity of ΔV₁· C_{IE,1} are extracted from the capacitor C1 via the charge moving capacitor C_{IE,1}, which causes a bump bp1 (with negative polarity) on a waveform of the voltage V_{C1}.

In other words, the waveform of the capacitor voltage can be regarded as comprising a bump (e.g., bp2) over an exponential decreasing within a discharging period of the capacitor (e.g., C2), or comprising a bump (e.g., bp1) over an exponential increasing within a charging period of the capacitor (e.g., C1).

During time period T2, the clock signal CLK is high and the complementary clock signal C̅L̅K̅ is low. The capacitor C1 is discharging and the capacitor C2 is charging. T2 can be regarded as a discharging period of the capacitor C1 and/or a charging period of the capacitor C2.

As the delayed clock signal CLK_{d} has a rising edge within the discharging period of the capacitor C1, electric charges with a quantity of ΔV₁· C_{IE,1} are injected into the capacitor C1 via the charge moving capacitor C_{IE,1}, which causes a bump (with positive polarity) on the waveform of the voltage V_{C1}. On the other hand, as the delayed-and-complementary clock signal C̅L̅K̅_{d} has a falling edge within the charging period of the capacitor C2, electric charges with a quantity of ΔV₂· C_{IE,2} are extracted from the capacitor C2 via the charge moving capacitor C_{IE,1}, which causes a bump (with negative polarity) on the waveform of the voltage V_{C2}.

Due to the injected/extracted electric charges or the bumps (e.g., bp1 or bp2), the (dis)charging period T1/T2 can be lengthened. Hence, frequency of the clock signal CLK can be adjusted/trimmed lower.

Note that, an amount of frequency adjustment can be determined by ΔV₁ or ΔV₂ (voltage change at the second end of the charge moving capacitor), capacitance of the charge moving capacitor C_{IE,1} or C_{IE,2}, and the delay time *t_{di}.*

In the embodiment shown in FIG. 9, unless specify otherwise, ΔV₁ = ΔV₂ = V_{DD}. In another embodiment, the second end of the charge moving capacitor C_{IE,1} or C_{IE,2} may receive another clock signal or another signal comprising step function, which means comprising sudden voltage change ΔV₁ or ΔV₂. In this case, ΔV₁ or ΔV₂ would become a control variable/parameter for frequency trimming.

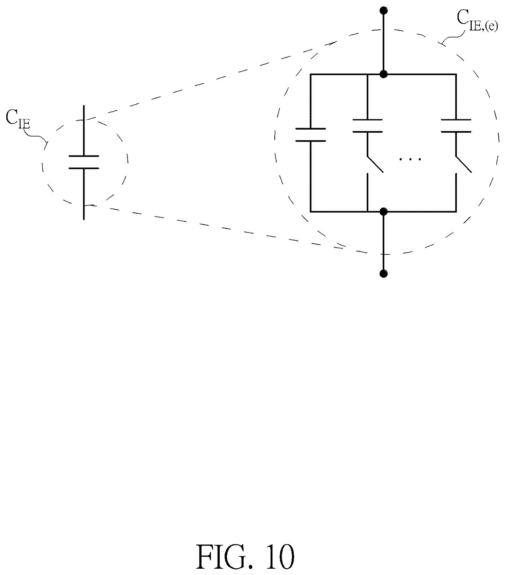

Capacitance of the charge moving capacitor C_{IE,1} or C_{IE,2} can be another control variable/parameter for frequency trimming. As mentioned earlier, capacitor of the present invention can be replaced with any component with capacitance. In this regard, the capacitance of the charge moving capacitor C_{IE,1} or C_{IE,2} may be adjustable. For example, referring to FIG. 10, the charge moving capacitor C_{IE,1} or C_{IE,2} in FIG. 8 may be realized by an equivalent charge moving capacitor C_{IE,(e)} shown in FIG. 10, where switch(es) within the equivalent charge moving capacitor C_{IE,(e)} may be configured to adjust the capacitance of the equivalent charge moving capacitor C_{IE,(e)}. The larger the capacitance, the longer the (dis)charging period, and thus the lower the clock frequency trimmed. In other words, a larger capacitance results in a longer charging and discharging period, thereby lowering the trimmed clock frequency.

Delay time *t_{di}* is also a control variable/parameter for frequency trimming, which is adjustable. Since the (dis)charging current is monotonically (exponentially) decreasing with respect to time, given certain amount of charge injected/extracted, the larger the delay time *t_{di},* the weaker the (dis)charging current and the longer the (dis)charging period, and thus the lower the clock frequency trimmed. In other words, a larger delay time *t_{di}* results in a longer charging and discharging period, thereby lowering the trimmed clock frequency.

Given the (dis)charging of RC circuit behaves monotonically (exponentially), the trimmed clock frequency decreases monotonically as the capacitance of the charge moving capacitor (e.g., C_{IE,1} or C_{IE,2}) or the delay time (e.g., *t_{di}*) increases. In this regard, the frequency-trimmable clock signal generator of the present invention (e.g., 40) can achieve very high resolution on clock frequency trimming.

There are several advantages of the frequency-trimmable clock signal generator of the present invention (e.g., 40). One advantage is that the amount of charge injected/extracted is fixed or controllable. As long as capacitance of the charge moving capacitor (e.g., C_{IE}) and voltage change at the second end of the charge moving capacitor (e.g., ΔV₁ or ΔV₂) are fixed, the amount of charge injected/extracted is fixed.

Another advantage is that minimum active circuit is included in the frequency-trimmable clock signal generator of the present invention, thereby noise introduced by the active circuit is minimized. Even delay element is included, the delay element would introduce jitter in an indirect way.

Another advantage is that the capacitance of the charge moving capacitor (e.g., C_{IE}) would isolate some noise and no active circuit is connected to the RC circuit.

In addition, the present invention provides a reliable frequency trimming methodology. The trimmed clock frequency is monotonic with respect to capacitance of the charge moving capacitor (e.g., C_{IE}) or the delay time (e.g., *t_{di}*), and it is possible to achieve very high resolution of frequency trimming.

The foregoing is only embodiments, but not limitations, of the present invention. Any modification following the spirit and principle of the present invention, equivalent substitutions, improvements should be included within the scope of the present invention.

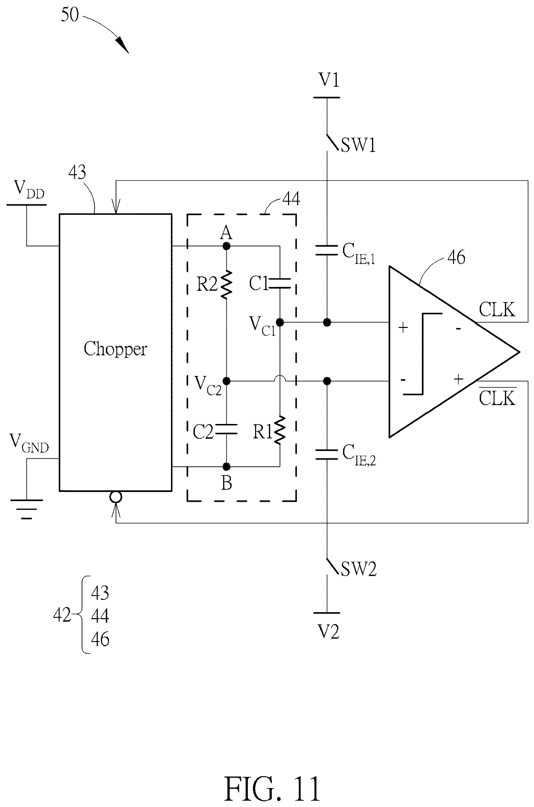

For example, FIG. 11 is a schematic diagram of a frequency-trimmable clock signal generator 50 according to an embodiment of the present invention. In FIG. 11, the second end of the charge moving capacitor C_{IE,1}/C_{IE,2} may receive a voltage V1/V2 via a switch SW1/SW2. The switch SW1/SW2 may provide a sudden voltage change to the voltage V1/V2 at the second end of the charge moving capacitor C_{IE,1}/C_{IE,2}, which is also within the scope of the present invention.

In conclusion, the frequency-trimmable clock signal generator of the present invention provides a high-resolution solution for precisely calibrating operating frequencies to match the specific resonant frequency of individual air pulse generating (APG) devices. By employing a charge injection/extraction mechanism through charge moving capacitors, the charging and discharging periods of the RC oscillation circuit can be adjusted monotonically with high precision. This approach not only ensures reliable frequency trimming to compensate for fabrication variations but also offers significant advantages such as low-noise operation, reduced jitter, and improved signal isolation due to the minimal reliance on active circuitry directly connected to the RC timing path. Consequently, the proposed invention enables optimal sound pressure level (SPL) performance in APG device of sound producing applications while maintaining a stable and predictable oscillation behavior.

## Claims

1. A clock signal generator (10), **characterized by** comprising:
an oscillation circuit (12), configured to generate a clock signal (CLK), comprising a comparator (16) and a resistor-capacitor (RC) circuit (14), wherein the RC circuit comprising a capacitor (C); and
a charge moving capacitor (C_{IE}), connected to the RC circuit;
wherein a frequency of the clock signal is trimmed by injecting or extracting electric charges associated with the RC circuit via the charge moving capacitor.

2. The clock signal generator (10) of claim 1, **characterized in that,**
a first end of the charge moving capacitor (C_{IE}) is coupled to the RC circuit (14); and
a second end of the charge moving capacitor (C_{IE}) changes to a first voltage from a second voltage.

3. The clock signal generator (40) of claim 2, **characterized in that,**
the second end of the charge moving capacitor receives the first signal comprising the rising edge within a discharging period (T1), or receives the second signal comprising the falling edge within a charging period (T2).

4. The clock signal generator (10b) of claims 1-3, **characterized by** comprising:
a delay element (DE), coupled between the comparator (16) and the charge moving capacitor (C_{IE});
wherein the delay element (DE) produces a delayed clock signal (CLK_{d}) to the charge moving capacitor according to the clock signal (CLK) outputted from the comparator;
wherein the delay element produces the delayed clock signal (CLK_{d}) having a delay time *(t_{di})* with respect to the clock signal (CLK).

5. The clock signal generator (10b) of claim 4, **characterized in that,**
the frequency of the clock signal (CLK) is trimmed by adjusting the delay time *(t_{di})* or a capacitance of the charge moving capacitor (C_{IE}).

6. The clock signal generator (20) of claims 1-5, **characterized in that,**
a waveform of a capacitor voltage (V_{C}) at the capacitor (C) comprises a bump (bp).

7. The clock signal generator (20) of claim 6, **characterized in that,**
the bump (bp) occurs when a delay time (*t_{d}*) after the oscillation circuit (22) transits states.

8. The clock signal generator (20) of claims 6-7, **characterized in that,**
the waveform of the capacitor voltage (V_{C}) comprises the bump (bp) over an exponential decreasing within a discharging period of the capacitor or over an exponential increasing within a charging period of the capacitor.

9. The clock signal generator (40) of claim 1, **characterized in that** the RC circuit comprises:
a first capacitor (C1) coupled to a first input terminal of the comparator (46); and
a second capacitor (C2) coupled to a second input terminal of the comparator (46).

10. The clock signal generator (40) of claim 9, **characterized by** comprising:
a first charge moving capacitor (C_{IE,1}) coupled to the first capacitor; and
a second charge moving capacitor (C_{IE,2}) coupled to the second capacitor.

11. The clock signal generator (40) of claim 10, **characterized by** comprising:
a first delay element (DE1), coupled between a first output terminal of the comparator and the first charge moving capacitor; and
a second delay element (DE2), coupled between a second output terminal of the comparator and the second charge moving capacitor.

12. The clock signal generator (40) of claim 11, **characterized in that,**
the first delay element (DE1) produces a delayed clock signal (CLK_{d}) to the first charge moving capacitor according to the clock signal (CLK) outputted from the first output terminal of the comparator;
the second delay element (DE2) produces a delayed-and-complementary clock signal (C̅L̅K̅_{d}) to the charge moving capacitor according to a complementary clock signal (C̅L̅K̅) outputted from the second output terminal of the comparator; and
the delayed clock signal has a delay time (*t_{di}*) with respect to the clock signal, and the delayed-and-complementary clock signal has the delay time (*t_{di}*) with respect to the complementary clock signal.

13. The clock signal generator (40) of claims 9-12, **characterized in that,**
a first waveform of a first capacitor voltage (V_{C1}) at the first capacitor comprises a first bump (bp1) toward a first polarity over an exponential decreasing within a discharging period of the first capacitor (T1);
a second waveform of a second capacitor voltage (V_{C2}) at the second capacitor comprises a second bump (bp2) toward a second polarity over an exponential increasing within a charging period of the second capacitor (T1);
the first polarity and the second polarity are opposite to each other; and
the discharging period of the first capacitor and the charging period of the second capacitor coincide with each other.

14. A frequency trimming method, **characterized by** being applied in a clock signal generator according to claims 1-13.

15. The frequency trimming method of claim 14, **characterized by** comprising:
increasing a voltage of an end of the charge moving capacitor during a discharging period of a capacitor of the RC circuit, or decreasing a voltage of an end of the charge moving capacitor during a charging period of a capacitor of the RC circuit.
